# EUROPÄISCHE PATENTSCHRIFT

(11) **EP 4 044 780 B1**
(45) Veröffentlichungstag und Bekanntmachung des Hinweises auf die Patenterteilung: **06.11.2024**
(21) Anmeldenummer: 22000043.4
(22) Anmeldetag: 10.03.2020
(51) Int. Cl.: H05K 7/20, H05K 5/04

(54) **ELEKTROGERÄT MIT GEHÄUSETEIL**
ELECTRICAL DEVICE WITH HOUSING PART
APPAREIL ELECTRIQUE AVEC PARTIE LOGEMENT

(30) Priorität: 10.04.2019 DE 102019002627
(43) Veröffentlichungstag der Anmeldung: 17.08.2022
(62) Teilanmeldung aus: 20711790.4
(73) Patentinhaber: SEW-EURODRIVE GmbH & Co. KG, 76646 Bruchsal (DE)
(72) Erfinder: Mayer, Ralph, D-76698 Ubstadt-Weiher (DE); Daminger, Franz, D-67067 Ludwigshafen am Rhein (DE)

(56) Entgegenhaltungen:
- WO-A1-2020/043323
- WO-A1-2020/043324
- US-A- 6 065 530
- US-B1- 10 080 311
- US-B1- 6 354 461

## Beschreibung

Die Erfindung betrifft ein Elektrogerät mit Gehäuseteil.

Es ist allgemein bekannt, dass Kühlrippen den konvektiv von einem Gehäuseteil abzutransportierenden Wärmestrom verbessern.

**Aus der** US 6 065 530 A **ist ein wasserfestes Gehäuse für eine Fernsteuerung bekannt.**

**Aus der** US 6 354 461 B1 **ist ein Gehäuseteil mit Kühlrippen bekannt.**

**Aus der** US 10 080 311 B1 **ist eine Kühlkörperstruktur bekannt.**

Der Erfindung liegt daher die Aufgabe zugrunde, den Abtransport von Wärme bei einem Elektrogerät zu verbessern.

Erfindungsgemäß wird die Aufgabe bei dem Elektrogerät nach den in Anspruch 1 angegebenen Merkmalen gelöst.

Wichtige Merkmale der Erfindung bei dem Elektrogerät mit Gehäuseteil sind, dass am Gehäuseteil erste, zweite und dritte Kühlrippen angeformt oder ausgeformt sind,
wobei das Gehäuseteil eine Wand, insbesondere Oberseite, und zwei Seitenwände aufweist,
wobei jede der Kühlrippen sich entlang der Wand und zumindest einer der Seitenwände erstreckt.

Von Vorteil ist dabei, dass Flüssigkeiten sich nicht ansammeln können und somit der Wärmestrom nicht durch angesammelte Flüssigkeitsmengen verringert ist. Insbesondere ist es erfindungsgemäß ermöglicht, den Wärmefluss von der Wand aus an die Kühlrippen zum Aufspreizen der Wärme weiterzuleiten. Durch die dünne Ausführung der Kühlrippen ist hier ein hochdynamisches Variieren des in die Wand eingetragenen Wärmestroms ermöglicht. Denn von den Kühlrippen wird der Wärmstrom aus dem Beriech der Wand bis in den Beriech der Seitenwände und den dort verdickten Bereich der Kühlrippen weitergeleitet. Auf diese Weise ist dort eine große Wärmekapazität ohne Wärmeübergangswiderstand realisierbar. Wird also ein hoher Wärmestrom in die Wand eingeleitet, wird dieser schnell über die Kühlrippen bis zu den in den Seitenwänden verdickten Bereichen der Kühlrippen weitergeleitet.

Durch die Umfassung von zwei oder drei Seiten des Gehäuseteils mittels einer jeweiligen Kühlrippe wird ein konvektiv angetriebener Luftstrom entlang der Kühlrippen in verschiedenen Raumlagen des Gehäuseteils angetrieben. Auf diese Weise ist also bei jeder Raumlage eine Entwärmung effizient ausführbar.

Das Elektrogerät ist vorzugsweise als Umrichter zur Speisung eines Elektromotors ausgeführt. Dabei sind kurzfristig hohe Leistungen, beispielsweise beim Beschleunigen des Elektromotors, erforderlich, was aber auch zu hohen thermischen Verlustleistungen der Leistungselektronik des Umrichters führt. Das erfindungsgemäß ausgebildete Gehäuseteil ermöglicht eine schnelle Aufspreizung des Wärmestroms hin zu einer entfernt von der Einströmstelle angeordneten Wärmekapazität, insbesondere also verdickten Bereichen der Kühlrippen und/oder Stegen.

Bei einer vorteilhaften Ausgestaltung erstrecken die ersten Kühlrippen sich entlang der Wand und einer ersten Seitenwand,
wobei die dritten Kühlrippen sich entlang der anderen, insbesondere zweiten, Seitenwand und der Wand erstrecken,
wobei die zweiten Kühlrippen sich entlang der Wand und der beiden Seitenwände erstrecken. Von Vorteil ist dabei, dass jede der Kühlrippen sich über zumindest zwei unterschiedliche, also auch unterschiedlich orientierte Wände erstrecken. Dabei ist jede der Wände grob gesehen eben ausgeführt oder zumindest in einer jeweiligen Vorzugsraumrichtung ausgerichtet. Somit erstreckt sich jede der Kühlrippen über zumindest zwei unterschiedliche Raumrichtungen.

Der Verlauf jeder der ersten, zweiten und dritten Kühlrippen weist jeweils zumindest einen bogenförmigen Bereich auf. Von Vorteil ist dabei, dass in zumindest zwei verschiedenen räumlichen Ausrichtungen des Gehäuseteils sich jeweils ein konvektiv angetriebener Luftstrom ausbildet. Denn wenn die Kühlrippen nur in jeweils einer einzigen Ebene erstrecken würden, wäre quer zu dieser Ebene kein konvektiv angetriebener Luftstrom ausbildbar.

Bei einer vorteilhaften Ausgestaltung weist der Verlauf der ersten Kühlrippen stets einen nicht positiven Krümmungsradius auf,
wobei der Verlauf der dritten Kühlrippen stets einen nicht negativen Krümmungsradius aufweist,
wobei der Verlauf der zweiten Kühlrippen in einem ersten Bereich einen positiven und in einem zweiten Bereich einen negativen Krümmungsradius aufweist,
insbesondere wobei der Verlauf von der jeweils senkrechten Projektion der jeweiligen Spitze der Kühlrippe auf die Oberfläche, insbesondere auf die jeweilige Seite, des Gehäuseteils dargestellt ist,
insbesondere wobei entlang der Erstreckung der Kühlrippe die Spitze der Kühlrippe jeweils der vom Gehäuseteil am weitesten entfernte Oberflächenpunkt ist. Von Vorteil ist dabei, dass in unterschiedlichen räumlichen Ausrichtungen des Gehäuseteils konvektiv angetriebene Luftströme ausbildbar sind und Flüssigkeiten abgeleitet werden.

Bei einer vorteilhaften Ausgestaltung weist in Erstreckungsrichtung der Verlauf der ersten Kühlrippen einen positiv gekrümmten Bogen auf,
wobei in Erstreckungsrichtung der Verlauf der dritten Kühlrippen einen negativ gekrümmten Bogen aufweist,
wobei in Erstreckungsrichtung der Verlauf der zweiten Kühlrippen in einem ersten Bereich einen positiv und in einem zweiten Bereich einen negativ gekrümmten Bogen aufweist, insbesondere wobei der Verlauf die senkrechte Projektion der Kühlrippenspitzen auf die Oberfläche, insbesondere auf die jeweilige Seite, des Gehäuseteils ist,
insbesondere wobei entlang der Erstreckung der Kühlrippe die Spitze der Kühlrippe jeweils der vom Gehäuseteil am weitesten entfernte Oberflächenpunkt ist. Von Vorteil ist dabei, dass in unterschiedlichen räumlichen Ausrichtungen des Gehäuseteils konvektiv angetriebene Luftströme ausbildbar sind und Flüssigkeiten abgeleitet werden.

Eine jeweilige an jeder der Seitenwände als Steg fungierende Verdickung der Wandstärke des Gehäuseteils verbindet zwei jeweils zueinander nächstbenachbarte Kühlrippen,
insbesondere wobei jede der Kühlrippen mit zumindest einem der Stege verbunden ist. Von Vorteil ist dabei, dass die Wärme von dem Wärmeerzeugenden Element in die Wand eingeleitet wird und mittels der Kühlrippen der eingeleitete Wärmestrom aufgespreizt wird bis zu der durch die Stege gebildeten hohen Wärmekapazität. Somit fließt der Wärmestrom in diese Wärmekapazität und wird von dort in gleichmäßiger Weise an die Umgebung abgeführt, insbesondere an einen konvektiv vorbeiströmenden Luftstrom, da die Stege weniger von der jeweiligen Seitenwand hervorragen als die Kühlrippen Bei einer vorteilhaften Ausgestaltung weisen alle an der ersten Seitenwand ausgebildeten Stege denselben Abstand zur Wand auf,
insbesondere zueinander kollinear angeordnet sind. Von Vorteil ist dabei, dass ein Luftstrom die Stege gleichmäßig überströmen kann.

Bei einer vorteilhaften Ausgestaltung sind alle an der zweiten Seitenwand ausgebildeten Stege in einer geraden Linie hintereinander, insbesondere nur durch jeweiligen Kühlrippen voneinander beabstandet, angeordnet,
insbesondere wobei jeder der Stege dieselbe Dicke aufweist und/oder gleichartig ausgeformt ist. Von Vorteil ist dabei, dass eine einfache Herstellung ermöglicht ist und ein effizientes Umströmen mit einem konvektiv angetriebenen Luftstrom ausbildbar ist, insbesondere laminar.

Die Wandstärke des Gehäuseteils ist im Bereich eines jeweiligen Steges kleiner als die Wandstärke des Gehäuseteils in dem jeweiligen, an den jeweiligen Steg angrenzenden Bereich der Kühlrippen. Von Vorteil ist dabei, dass der Luftstrom trotz der Stege im zwischen den jeweils nächstbenachbarten Kühlrippen ausgebildeten Kanal führbar ist.

Bei einer vorteilhaften Ausgestaltung sind die Seitenwände im Wesentlichen senkrecht zur Wand, insbesondere Oberseite, ausgerichtet. Von Vorteil ist dabei, dass in verschiedenen räumlichen Ausrichtungen ein konvektiv angetriebener Luftstrom ausbildbar ist.

Bei einer vorteilhaften Ausgestaltung nimmt, insbesondere an den Seitenwänden, die Wandstärke der ersten, zweiten und dritten Kühlrippen mit zunehmendem Abstand zur Wand monoton, insbesondere streng monoton, zu. Von Vorteil ist dabei, dass eine erhöhte Wärmekapazität nahe an der Seitenwand bereit stellbar ist. Somit wirken diese Verdickungen zusammen mit den Stegen als Erhöhung der Wärmekapazität.

Die Wandstärke des sich an der Wand erstreckenden Bereichs der ersten, zweiten und dritten Kühlrippen weist mit zunehmendem Abstand von der Wand **eine** abnehmende Wandstärke auf,
und wobei die Wandstärke des sich an der ersten Seitenwand erstreckenden Bereichs der ersten, zweiten und dritten Kühlrippen mit zunehmendem Abstand von der ersten Seitenwand **eine** abnehmende Wandstärke aufweist,
und wobei die Wandstärke des sich an der zweiten Seitenwand erstreckenden Bereichs der ersten, zweiten und dritten Kühlrippen mit zunehmendem Abstand von der zweiten Seitenwand **eine** abnehmende Wandstärke aufweist. Von Vorteil ist dabei, dass die Wärmekapazität nah an der Seitenwand erhöht ausgebildet ist.

Bei einer vorteilhaften Ausgestaltung ist Gehäuseteil als Metallgussteil hergestellt. Von Vorteil ist dabei, dass eine kostengünstige einfache Herstellung ermöglicht ist.

Bei einer vorteilhaften Ausgestaltung ist **ein** Wärme erzeugendes Bauteil, insbesondere ein **einen** steuerbaren Leistungshalbleiter aufweisendes Modul, an der Innenseite der Wand mit dem Gehäuseteil wärmeleitend verbunden. Von Vorteil ist dabei, dass das Bauteil in einfacher Weise entwärmbar ist. insbesondere auch bei hochdynamischem Betrieb ist ein schnelles Aufnehmen der Wärme durch Aufspreizen erreichbar und ein gleichmäßiges Abfließen der Wärme an die Umgebung aus der erhöhten Wärmekapazität der Stege und der verdickten Kühlrippenbereiche.

Bei einer vorteilhaften Ausgestaltung ist die erste Seitenwand parallel zur zweiten Seitenwand ausgerichtet,
wobei die Wand senkrecht zur ersten und zweiten Seitenwand ausgerichtet ist. Von Vorteil ist dabei, dass eine in zumindest drei verschiedenen räumlichen Orientierungen effiziente Entwärmung ausführbar ist.

Die Erfindung wird nun anhand von schematischen Abbildungen näher erläutert:
In der Figur 1 ist ein Kühlrippen (1, 2, 3) aufweisendes Gehäuseteil 5 eines Elektrogeräts dargestellt.

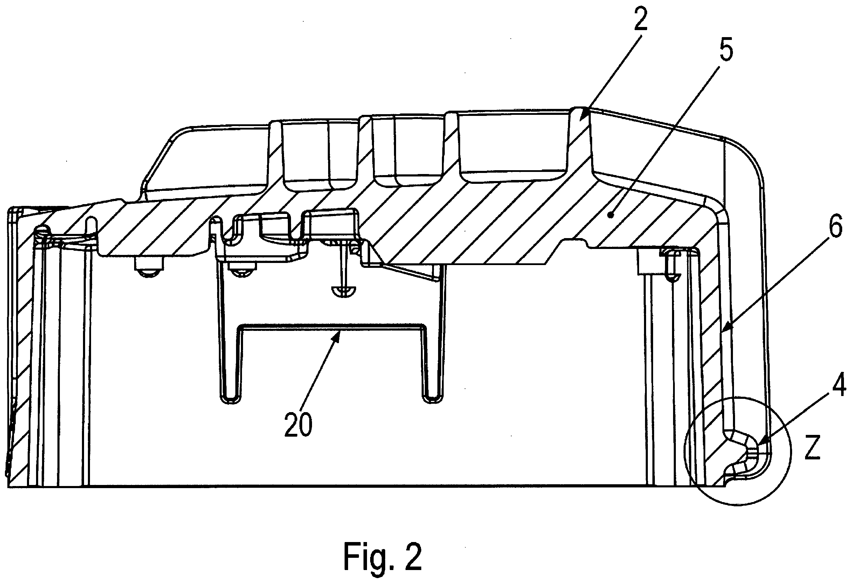

In der Figur 2 ist ein Querschnitt durch das Gehäuseteil 5 dargestellt.

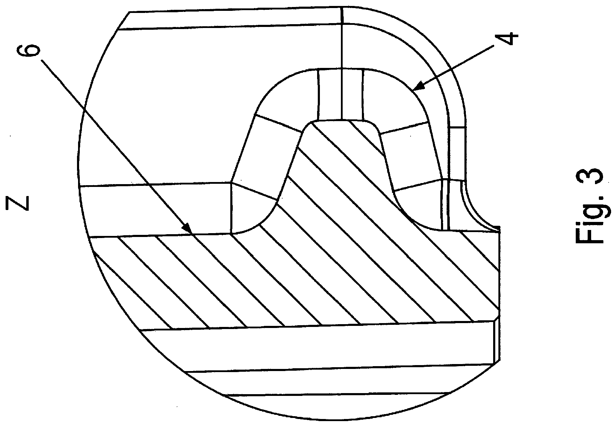

In der Figur 3 ist ein vergrößerter Ausschnitt der Figur 2 dargestellt.
In der Figur 4 sind verschiedenen räumliche Ausrichtungen des Gehäuseteils 5 dargestellt.

Wie in den Figuren gezeigt, weist das Gehäuseteil 5 Kühlrippen (1, 2, 3) auf.

Dabei erstrecken sich erste Kühlrippen 1 über eine Seitenwand und die Oberseite des Gehäuseteils 5.

Zweite Kühlrippen 2 erstrecken sich über die Seitenwand, die Oberseite und eine weitere Seitenwand des Gehäuseteils 5.

Dritte Kühlrippen 3 erstrecken sich über die weitere Seitenwand und die Oberseite des Gehäuseteils 5.

**Die ersten Kühlrippen 1 verlaufen nicht geradlinig, sondern gebogen. Entlang ihrer Erstreckung an der Oberfläche des Gehäuseteils 5 weist der Verlauf der ersten Kühlrippen 1 einen Bogen auf, insbesondere welcher idealisiert einem Viertelkreisbogen entspricht. Der Bogen ist an der Oberseite des Gehäuseteils 5 angeordnet.**

**Der Verlauf der zweiten Kühlrippen 2 weist entlang der Erstreckung der zweiten Kühlrippen 2 an der Oberfläche, insbesondere Oberseite, des Gehäuseteils 5 einen Doppelbogen auf, wobei der erste Bogen umgekehrt gekrümmt zum zweiten Bogen des Doppelbogens verläuft.**

**Die dritten Kühlrippen 3 verlaufen ebenfalls nicht geradlinig, sondern gebogen. Entlang ihrer Erstreckung an der Oberfläche des Gehäuseteils 5 weist der Verlauf der dritten Kühlrippen 3 ebenfalls einen Bogen auf, insbesondere welcher idealisiert einem Viertelkreisbogen entspricht. Der Bogen ist ebenfalls an der Oberseite des Gehäuseteils 5 angeordnet, aber umgekehrt gekrümmt im Vergleich zu dem Bogen des Verlaufs der ersten Kühlrippen 1.**

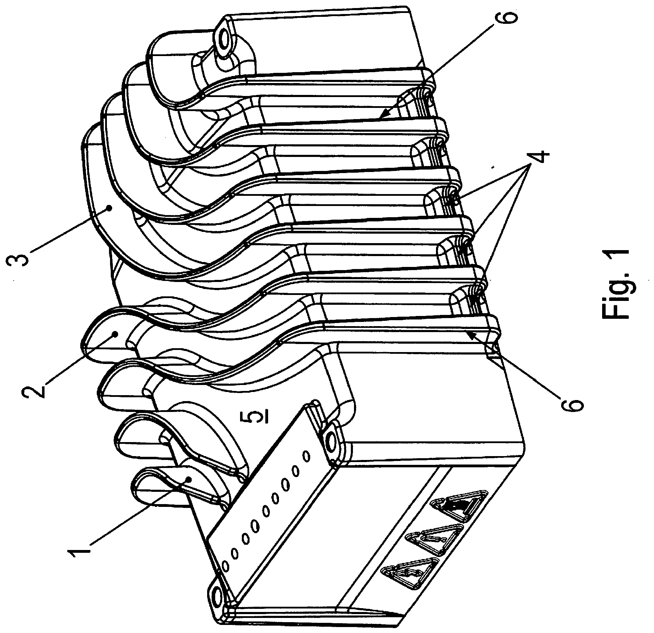

Wie in Figur 1 dargestellt sind am Gehäuseteil 5 zwei erste Kühlrippen 1, zwei zweite Kühlrippen 2 und vier dritte Kühlrippen 3 ausgeformt.

An den beiden Seitenwänden weisen die ersten, zweiten und dritten Kühlrippen (1, 2, 3) jeweils mit zunehmender Entfernung von der Oberseite eine insbesondere monoton oder sogar streng monoton zunehmende Wandstärke auf.

Im von dem Gehäuseteil 5 umgebenen Innenraum ist ein Wärmeerzeugendes Element, insbesondere steuerbarer Halbleiterschalter oder Modul mit steuerbaren Halbleiterschaltern. Zur Einleitung des Wärmestroms des Wärmeerzeugenden Elements weist das Gehäuseteil 5 an seiner Innenseite, insbesondere mittig in der Oberseite, eine fein bearbeitete Fläche, nämlich die Verbindungsfläche 20, auf, an welche das Wärmeerzeugende Element anliegt, insbesondere von Schrauben oder von einem Federelement angedrückt wird. Somit fließt der Wärmestrom mittig in die Oberseite ein und wird dann von der Oberseite aufgespreizt und auch in die Kühlrippen (1, 2, 3) geleitet.

Da die Kühlrippen (1, 2, 3) an der Oberseite dünn ausgeführt sind, folgt die Temperatur der Kühlrippen (1, 2,3) dem Temperaturverlauf des Wärmeerzeugenden Elements wenig zeitverzögert und ohne wesentliche Differenz oder mit einer konstanten Differenz.

Somit ist ein dynamisches Aufspreizen des Wärmestroms ausführbar. Bei Schwankungen der Leistung des Elektrogeräts, insbesondere Umrichters, und somit des Wärmestroms nimmt die Oberseite somit den Wärmestrom schnell auf. An den Seitenwänden sind die Kühlrippen mit zunehmender Entfernung von der Oberseite zunehmend dicker ausgeführt. Somit ist hier eine erhöhte Wärmekapazität vorhanden und daher dort eine gleichmäßigere Wärmeabgabe an die Umgebung ermöglicht. Die gröbere Wärmekapazität in diesen Bereichen verhindert ein hochdynamisches Schwanken. Das Aufnahmevermögen für Wärmeenergie ist aber viel höher.

An den beiden Seitenwänden sind außerdem zusätzliche Verdickungen ausgeführt, die als Stege 4 zwischen den Kühlrippen (1, 2, 3) fungieren. Hierbei verbindet jeweils ein Steg 4 zwei zueinander nächstbenachbarte Kühlrippen (1, 2, 3). Die Wandstärke des Gehäuseteils 5 im Bereich der Stege 4 ist geringer als im an die Stege jeweils angrenzenden Bereiche der Kühlrippen (1, 2, 3).

Vorzugsweise sind die Kühlrippen (1, 2, 3) an den Seitenwänden äquidistant zueinander angeordnet und weisen zu ihren jeweils nächstbenachbarten Kühlrippen (1, 2, 3) einen Mindestabstand auf. An der Oberseite wird eine Mindestdistanz der Kühlrippen (1, 2,3) zueinander eingehalten. Somit verlaufen dort die Kühlrippen zu ihren nächstbenachbarten Kühlrippen (1, 2, 3) an der Oberseite parallel mit dem Mindestabstand oder der Abstand ist monoton zunehmend oder abnehmend, aber stets größer als der Mindestabstand.

Die Stege 4 sind kollinear angeordnet, insbesondere also in einer geraden Linie. Somit weisen die Stege 4 alle denselben Abstand von der Oberseite auf

Die Wandstärke der Kühlrippen (1, 2, 3) ist an der Oberseite des Gehäuseteils 5 konstant.

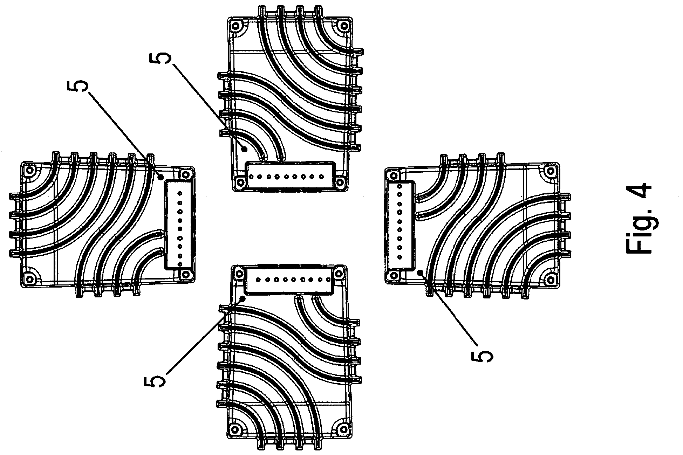

Wie in Figur 4 gezeigt, wird Wasser in mehreren verschiedenen räumlichen Ausrichtungen des Gehäuseteils abgeleitet. Bei diesen Orientierungen kann es sich also in keinem Bereich ansammeln.

Bei weiteren erfindungsgemäßen Ausführungsbeispielen weisen die Kühlrippen (1, 2, 3) überall eine mit zunehmendem Abstand von der jeweilig nächstliegenden Seite des Gehäuseteils 5 monoton oder sogar streng monoton abnehmende Wandstärke auf. Trotzdem weisen die ersten, zweiten und dritten Kühlrippen (1, 2, 3) an den beiden Seitenwänden mit zunehmender Entfernung von der Oberseite eine insbesondere monoton oder sogar streng monoton zunehmende Wandstärke auf.

### Bezugszeichenliste

1 Kühlrippe
2 Kühlrippe
3 Kühlrippe
4 Steg
5 Gehäuseteil
6 verdickter Bereich
20 Verbindungsfläche

## Patentansprüche

1. Elektrogerät mit Gehäuseteil (5),
wobei am Gehäuseteil (5) erste, zweite und dritte Kühlrippen (1, 2, 3) angeformt oder ausgeformt sind,
wobei das Gehäuseteil (5) eine Wand, insbesondere Oberseite, und zwei Seitenwände aufweist,
**wobei** jede der Kühlrippen (1, 2, 3) sich entlang der Wand und zumindest einer der Seitenwände erstreckt,
wobei **die ersten Kühlrippen (1) gebogen verlaufen, also entlang ihrer Erstreckung an der Oberfläche des Gehäuseteils (5) jeweils einen Bogen aufweisen, insbesondere welcher idealisiert einem Viertelkreisbogen entspricht, wobei der Bogen an der Oberseite des Gehäuseteils (5) angeordnet ist,**
**wobei die dritten Kühlrippen (3) gebogen verlaufen, also entlang ihrer Erstreckung an der Oberfläche des Gehäuseteils (5) ebenfalls einen Bogen aufweisen, insbesondere welcher idealisiert einem Viertelkreisbogen entspricht, wobei der Bogen ebenfalls an der Oberseite des Gehäuseteils (5) angeordnet ist, aber umgekehrt gekrümmt ist im Vergleich zu dem Bogen des Verlaufs der ersten Kühlrippen (1),**
**wobei der Verlauf der zweiten Kühlrippen (2) entlang der Erstreckung der zweiten Kühlrippen (2) an der Oberfläche, insbesondere Oberseite, des Gehäuseteils (5) einen Doppelbogen aufweist, wobei der erste Bogen des Doppelbogens umgekehrt gekrümmt verläuft zum zweiten Bogen des Doppelbogens,**
**wobei an jeder der Seitenwände eine jeweilige, als Steg (4) fungierende Verdickung der Wandstärke des Gehäuseteils (5) zwei jeweils zueinander nächstbenachbarte Kühlrippen (1, 2, 3)** verbindet, **dadurch gekennzeichnet dass**
**die Wandstärke des Gehäuseteils (5) im Bereich eines jeweiligen Steges (4) kleiner ist als die Wandstärke des Gehäuseteils (5) in dem jeweiligen, an den jeweiligen Steg (4) angrenzenden Bereich der Kühlrippen (1, 2, 3).**
**die Wandstärke des sich an der Wand erstreckenden Bereichs der ersten, zweiten und** dritten Kühlrippen (1, 2, 3) mit zunehmendem Abstand von der Wand eine abnehmende Wandstärke aufweist,
und wobei die Wandstärke des sich an der ersten Seitenwand erstreckenden Bereichs der ersten, zweiten und dritten Kühlrippen (1, 2, 3) mit zunehmendem Abstand von der ersten Seitenwand eine abnehmende Wandstärke aufweist,
und wobei die Wandstärke des sich an der zweiten Seitenwand erstreckenden Bereichs der ersten, zweiten und dritten Kühlrippen (1, 2, 3) mit zunehmendem Abstand von der zweiten Seitenwand eine abnehmende Wandstärke aufweist.

2. Elektrogerät nach Anspruch 1
**dadurch gekennzeichnet, dass**
die ersten Kühlrippen (1) sich entlang der Wand und einer ersten Seitenwand erstrecken,
wobei die dritten Kühlrippen (3) sich entlang der anderen, insbesondere zweiten, Seitenwand und der Wand erstrecken,
wobei die zweiten Kühlrippen (2) sich entlang der Wand und der beiden Seitenwände erstrecken.

3. Elektrogerät nach einem der vorangegangenen Ansprüche,
**dadurch gekennzeichnet, dass**
**jede der Kühlrippen (1, 2, 3) mit zumindest einem der Stege (4) verbunden ist.**

4. Elektrogerät nach einem der vorangegangenen Ansprüche,
**dadurch gekennzeichnet, dass**
alle an der ersten Seitenwand ausgebildeten Stege (4) denselben Abstand zur Wand aufweisen,
insbesondere zueinander kollinear angeordnet sind.

5. Elektrogerät nach einem der vorangegangenen Ansprüche,
**dadurch gekennzeichnet, dass**
alle an der zweiten Seitenwand ausgebildeten Stege (4) in einer geraden Linie hintereinander, insbesondere nur durch jeweiligen Kühlrippen (1, 2, 3) voneinander beabstandet, angeordnet sind.

6. Elektrogerät nach Anspruch 5
**dadurch gekennzeichnet, dass**
**jeder der Stege (4) dieselbe Dicke aufweist und/oder gleichartig ausgeformt ist.**

7. Elektrogerät nach einem der vorangegangenen Ansprüche,
**dadurch gekennzeichnet, dass**
die Seitenwände im Wesentlichen senkrecht zur Wand, insbesondere Oberseite, ausgerichtet sind.

8. Elektrogerät nach einem der vorangegangenen Ansprüche,
**dadurch gekennzeichnet, dass**
insbesondere an den Seitenwänden, die Wandstärke der ersten, zweiten und dritten Kühlrippen (1, 2, 3) mit zunehmendem Abstand zur Wand monoton, insbesondere streng monoton, zunimmt.

9. **Elektrogerät nach einem der vorangegangenen Ansprüche,**
**dadurch gekennzeichnet, dass**
**Gehäuseteil (5) als Metallgussteil hergestellt ist.**

10. **Elektrogerät nach einem der vorangegangenen Ansprüche,**
**dadurch gekennzeichnet, dass**
ein Wärme erzeugendes Bauteil, insbesondere **ein einen** steuerbaren Leistungshalbleiter aufweisendes Modul, an der Innenseite der Wand mit dem Gehäuseteil (5) wärmeleitend verbunden ist.

11. Elektrogerät nach einem der vorangegangenen Ansprüche,
**dadurch gekennzeichnet, dass**
die erste Seitenwand parallel zur zweiten Seitenwand ausgerichtet ist,
wobei die Wand senkrecht zur ersten und zweiten Seitenwand ausgerichtet ist.

## Claims

1. Electrical device with a housing part (5),
wherein first, second and third cooling fins (1, 2, 3) are moulded or formed on the housing part (5),
wherein the housing part (5) has a wall, in particular a top, and two side walls,
wherein each of the cooling fins (1, 2, 3) extends along the wall and at least one of the side walls,
wherein the first cooling fins (1) extend in an arcuate manner, i.e. each have an arc along their extension on the surface of the housing part (5), in particular which arc ideally corresponds to a quarter-circle arc, the arc being arranged on the top of the housing part (5),
wherein the third cooling fins (3) extend in an arcuate manner, i.e. likewise have an arc along their extension on the surface of the housing part (5), in particular which arc ideally corresponds to a quarter-circle arc, the arc likewise being arranged on the top of the housing part (5) but being inversely curved in comparison to the arc of the course of the first cooling fins (1),
wherein the course of the second cooling fins (2) has a double arc along the extension of the second cooling fins (2) on the surface, in particular on the top, of the housing part (5), the first arc of the double arc extending in an inversely curved manner in comparison to the second arc of the double arc,
wherein a respective thickened portion of the wall thickness of the housing part (5), which acts as a connecting strip (4) on each of the side walls, connects two cooling fins (1, 2, 3) that are in each case next-adjacent to each other,
**characterized in that**
the wall thickness of the housing part (5) in the region of a respective connecting strip (4) is smaller than the wall thickness of the housing part (5) in the respective region of the cooling fins (1, 2, 3) which adjoins the respective connecting strip (4),
the wall thickness of the region of the first, second and third cooling fins (1, 2, 3) that extends on the wall has a wall thickness that decreases as the distance from the wall increases,
and wherein the wall thickness of the region of the first, second and third cooling fins (1, 2, 3) that extends on the first side wall has a wall thickness that decreases as the distance from the first side wall increases,
and wherein the wall thickness of the region of the first, second and third cooling fins (1, 2, 3) that extends on the second side wall has a wall thickness that decreases as the distance from the second side wall increases.

2. Electrical device according to claim 1,
**characterized in that**
the first cooling fins (1) extend along the wall and a first side wall,
wherein the third cooling fins (3) extend along the other, in particular second, side wall and the wall,
wherein the second cooling fins (2) extend along the wall and the two side walls.

3. Electrical device according to any of the preceding claims, **characterized in that**
each of the cooling fins (1, 2, 3) is connected to at least one of the connecting strips (4).

4. Electrical device according to any of the preceding claims, **characterized in that**
all the connecting strips (4) formed on the first side wall are at the same distance from the wall,
in particular are arranged colinear to one another.

5. Electrical device according to any of the preceding claims, **characterized in that**
all the connecting strips (4) formed on the second side wall are arranged in a straight line one behind the other, in particular spaced apart from each other only by respective cooling fins (1, 2, 3).

6. Electrical device according to claim 5,
**characterized in that**
each of the connecting strips (4) has the same thickness and/or is of identical shape.

7. Electrical device according to any of the preceding claims, **characterized in that**
the side walls are oriented substantially perpendicular to the wall, in particular the top.

8. Electrical device according to any of the preceding claims, **characterized in that**
the wall thickness of the first, second and third cooling fins (1, 2, 3), in particular on the side walls, increases monotonically, in particular strictly monotonically, as the distance from the wall increases.

9. Electrical device according to any of the preceding claims, **characterized in that**
the housing part (5) is produced as a cast metal part.

10. Electrical device according to any of the preceding claims, **characterized in that**
a heat-generating component, in particular a module having a controllable power semiconductor, is connected to the housing part (5) in a thermally conductive manner on the inner side of the wall.

11. Electrical device according to any of the preceding claims, **characterized in that**
the first side wall is oriented parallel to the second side wall,
wherein the wall is oriented perpendicular to the first and second side wall.

## Revendications

1. Appareil électrique avec partie boîtier (5),
dans lequel des première, deuxième et troisième ailettes de refroidissement (1, 2, 3) sont moulées ou formées au niveau de la partie boîtier (5),
la partie boîtier (5) présentant une paroi, en particulier une face supérieure, et deux parois latérales,
chacune des ailettes de refroidissement (1, 2, 3) s'étendant le long de la paroi et d'au moins une des parois latérales,
les premières ailettes de refroidissement (1) étant courbées, présentant par conséquent chacune un arc le long de leur étendue au niveau de la face supérieure de la partie boîtier (5), en particulier qui correspond idéalement à un arc en quart de cercle, l'arc étant agencé sur la face supérieure de la partie boîtier (5),
les troisièmes ailettes de refroidissement (3) étant courbées, présentant par conséquent un arc le long de leur étendue au niveau de la face supérieure de la partie boîtier (5), en particulier qui correspond idéalement à un arc en quart de cercle, l'arc étant également agencé au niveau de la face supérieure de la partie boîtier (5), mais étant courbé de manière inverse par rapport à l'arc du tracé des premières ailettes de refroidissement (1),
le tracé des deuxièmes ailettes de refroidissement (2) le long de l'étendue des deuxièmes ailettes de refroidissement (2) présentant à la surface, en particulier au niveau de la face supérieure, de la partie boîtier (5) un double arc, le premier arc du double arc étant courbé de manière inverse par rapport au deuxième arc du double arc,
un épaississement respectif de l'épaisseur de paroi de la partie boîtier (5) faisant office d'entretoise (4) et reliant deux ailettes de refroidissement (1, 2, 3) respectivement voisines l'une de l'autre, au niveau de chacune des parois latérales, **caractérisé en ce que**
l'épaisseur de paroi de la partie boîtier (5), dans la région d'une entretoise (4) respective est inférieure à l'épaisseur de paroi de la partie boîtier (5) dans la région respective des ailettes de refroidissement (1, 2, 3) adjacente à l'entretoise (4) respective.
l'épaisseur de paroi de la région des premières, deuxièmes et troisièmes ailettes de refroidissement (1, 2, 3) s'étendant au niveau de la paroi présente une épaisseur de paroi décroissante à mesure que la distance par rapport à la paroi augmente,
l'épaisseur de paroi de la région des premières, deuxièmes et troisièmes ailettes de refroidissement (1, 2, 3) qui s'étend au niveau de la première paroi latérale présentant une épaisseur de paroi décroissante à mesure que la distance par rapport à la première paroi latérale augmente,
l'épaisseur de paroi de la région des premières, deuxièmes et troisièmes ailettes de refroidissement (1, 2, 3) qui s'étend au niveau de la deuxième paroi latérale présentant une épaisseur de paroi décroissante à mesure que la distance par rapport à la deuxième paroi latérale augmente.

2. Appareil électrique selon la revendication 1,
**caractérisé en ce que**
les premières ailettes de refroidissement (1) s'étendent le long de la paroi et d'une première paroi latérale,
les troisièmes ailettes de refroidissement (3) s'étendant le long de l'autre, en particulier deuxième, paroi latérale et de la paroi,
les deuxièmes ailettes de refroidissement (2) s'étendant le long de la paroi et des deux parois latérales.

3. Appareil électrique selon l'une quelconque des revendications précédentes,
**caractérisé en ce que**
chacune des ailettes de refroidissement (1, 2, 3) est reliée à au moins une des entretoises (4).

4. Appareil électrique selon l'une quelconque des revendications précédentes,
**caractérisé en ce que**
toutes les entretoises (4) formées au niveau de la première paroi latérale présentent la même distance par rapport à la paroi,
en particulier sont disposées de manière colinéaire les unes par rapport aux autres.

5. Appareil électrique selon l'une quelconque des revendications précédentes,
**caractérisé en ce que**
toutes les entretoises (4) formées au niveau de la deuxième paroi latérale sont agencées sur une ligne droite les unes derrière les autres, en n'étant en particulier espacées les unes des autres que par des ailettes de refroidissement (1, 2, 3) respectives.

6. Appareil électrique selon la revendication 5,
**caractérisé en ce que**
chacune des entretoises (4) présente la même épaisseur et/ou est de forme similaire.

7. Appareil électrique selon l'une quelconque des revendications précédentes,
**caractérisé en ce que**
les parois latérales sont orientées de manière essentiellement perpendiculaire à la paroi, en particulier à la face supérieure.

8. Appareil électrique selon l'une quelconque des revendications précédentes,
**caractérisé en ce que**
en particulier au niveau des parois latérales, l'épaisseur de paroi des premières, deuxièmes et troisièmes ailettes de refroidissement (1, 2, 3) augmente de manière monotone, en particulier de manière strictement monotone, à mesure que la distance par rapport à la paroi augmente.

9. Appareil électrique selon l'une quelconque des revendications précédentes, **caractérisé en ce que**
la partie boîtier (5) est fabriquée sous la forme d'une pièce moulée en métal.

10. Appareil électrique selon l'une quelconque des revendications précédentes,
**caractérisé en ce que**
un composant générant de la chaleur, en particulier un module présentant des semiconducteurs de puissance pouvant être commandés, est relié de manière thermoconductrice à la partie boîtier (5) au niveau de la face intérieure de la paroi.

11. Appareil électrique selon l'une quelconque des revendications précédentes,
**caractérisé en ce que**
la première paroi latérale est orientée de manière parallèle à la deuxième paroi latérale,
la paroi étant orientée de manière perpendiculaire aux première et seconde parois latérales.
